# EUROPÄISCHE PATENTANMELDUNG

(11) **EP 0 563 768 A1**
(43) Veröffentlichungstag der Anmeldung: **06.10.1993**
(21) Anmeldenummer: 93104832.6
(22) Anmeldetag: 24.03.1993
(51) Int. Cl.: G03G 5/06, G03G 5/07, C09K 19/34

(54) **Organische Photoleiter mit flüssigkristallinen Eigenschaften**

(30) Priorität: 03.04.1992 DE 4211087
(71) Anmelder: BASF Aktiengesellschaft, D-67063 Ludwigshafen (DE)
(72) Erfinder: Closs, Friedrich, Dr., 68165 Mannheim (DE); Frey, Thomas, Dr., W-4400 Muenster (DE); Funhoff, Dirk, Dr., W-6900 Heidelberg (DE); Siemensmeyer, Karl, Dr., W-6710 Frankenthal (DE); Tschierske, Carsten, Dr., W-4070 Halle/Saale (DE); Haarer, Dietrich, Prof. Dr., W-8580 Bayreuth (DE); Strohriegl, Peter, Dr., W-8581 Hummeltal (DE)

(57) **Zusammenfassung**

Die Erfindung betrifft Photoleiter aus niedermolekularen oder polymeren organischen Verbindungen mit flüssigkristallinen Eigenschaften, deren Photoleitung in den kalamitischen Phasen höher als in den nichtflüssigkristallinen Phasen ist.

Diese Photoleiter eignen sich für elektrophotographische Aufzeichnungsmaterialien.

## Beschreibung

Die Erfindung betrifft Photoleiter aus niedermolekularen oder polymeren organischen Verbindungen mit flüssigkristallinen Eigenschaften. Die Erfindung betrifft insbesondere derartige organische Photoleiter mit flüssigkristallinen Eigenschaften, die im flüssigkristallinen Zustand eine erhöhte Photoleitfähigkeit aufweisen. Die Erfindung betrifft außerdem ein Verfahren zur Erhöhung der Photoleitung durch molekulare Ordnung, bei dem die Photoleitfähigkeit in geordneten flüssigkristallinen Systemen erhöht wird. Die Begriffe "Zustand" und "Phase" werden im folgenden gleichbedeutend verwendet.

Photoleitende Polymere sind eine interessante Materialklasse und werden in Kopierern, Laserdruckern und Offset-Druckplatten in großem Umfang technisch eingesetzt.

Es sind mehrere Versuche bekannt, die Ladungstransporteigenschaften flüssigkristalliner Materialien durch Orientierung im flüssigkristallinen Zustand zu verbessern. Hierzu gibt es zwei Ansätze.

Einmal werden niedermolekulare Flüssigkristalle, die bei Raumtemperatur nematische Phasen bilden, mit Carbazol dotiert. Hierbei ist die Aufnahmekapazität der flüssigkristallinen Matrix allerdings sehr beschränkt. Bereits bei sehr geringen Konzentrationen (wenige Gew.-%) beginnt das Carbazol zu kristallisieren. Dementsprechend gibt es nur einen geringen Photostrom der mit Carbazol dotierten Flüssigkristallproben (vgl. L.L. Chapoy, D.K. Munck, K.H. Rasmussen, E. Juul-Diekmann, R.K. Sethi, D. Biddle, in Molecular Crystals, Liquid Crystals, Vol. 105, S. 353ff. (1984)).

Aus der EP-A 254 060 sind photoleitfähige Filme mit einer Dicke unterhalb 20 µm bekannt, die aus konzentrierten lyophasischen Lösungen eines Polymers hergestellt werden, das eine Wiederholungseinheit der Formel 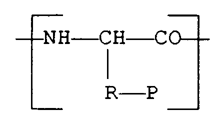
aufweist, wobei R ein Alkylradikal mit 1 bis 20 Kohlenstoffatomen und P eine photoleitfähige Gruppe ist.

Derartige Systeme eignen sich jedoch nicht zur Herstellung elektrophotographischer Aufzeichnungsmaterialien.

Aufgabe der vorliegenden Erfindung ist es, organische Photoleiter mit flüssigkristallinen Eigenschaften bereitzustellen, die im flüssigkristallinen Zustand eine höhere Photoleitfähigkeit aufweisen als im nicht-flüssigkristallinen.

Überraschenderweise läßt sich diese Aufgabe durch flüssigkristalline Photoleiter mit kalamitischen (nematisch oder smektisch) Eigenschaften lösen.

Gegenstand der vorliegenden Erfindung sind Photoleiter aus niedermolekularen oder polymeren organischen Verbindungen mit flüssigkristallinen Eigenschaften, die dadurch gekennzeichnet sind, daß deren Photoleitung in den kalamitischen Phasen höher als in den nichtflüssigkristallinen Phasen ist. Bevorzugt als derartige Photoleiter sind Thiadiazol-, Oxdiazol- oder Carbazolderivate.

Bevorzugt ist außerdem, derartige Photoleiter mit einem Zusatz einer ladungserzeugenden Komponente (Sensibilisator) zu versehen.

Gegenstand der vorliegenden Erfindung ist auch die Verwendung erfindungsgemäßer flüssigkristalliner Phasen von niedermolekularen oder polymeren kalamitischen Photoleitern für Ladungsträgerschichten in elektrophotographischen Aufzeichnungsmaterialien und ein elektrophotographisches Aufzeichnungsmaterial, bestehend aus einem elektrisch leitenden Schichtträger, einer Ladungsträger erzeugenden Sensibilisatorschicht und einer photoleitfähigen Schicht, das als photoleitfähige Schicht einen oder mehrere erfindungsgemäße Photoleiter enthält.

Die Erhöhung der Photoleitfähigkeit in erfindungsgemäßen Photoleitern mit kalamitischen Eigenschaften kann auch durch eine homogen planare oder homöotrope Orientierung der Ladungsträgermoleküle erreicht werden, wobei die Ladungsträgermoleküle durch mechanisches Scheren oder Strecken, durch Anlegen eines elektrischen oder magnetischen Feldes oder durch thermische Behandlung orientiert werden können.

Erfindungsgemäße niedermolekulare organische flüssigkristalline Photoleiter mit kalamitischen Eigenschaften sind insbesondere Thiadiazol- und Oxdiazolderivate, von denen die alkyl-, alkoxy-, und aryloxy-substituierten 1,3,4-Thiadiazole und 1,3,4-Oxdiazole bevorzugt sind, sowie Carbazolderivate. Derartige niedermolekulare 1,3,4-Thiadiazol- und 1,3,4-Oxadiazolderivate entsprechen den allgemeinen Formeln 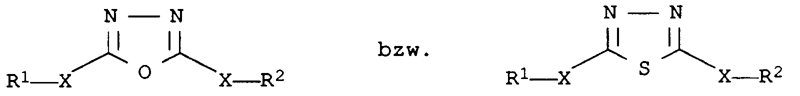
worin X für eine Einfachbindung oder die zweiwertigen Reste 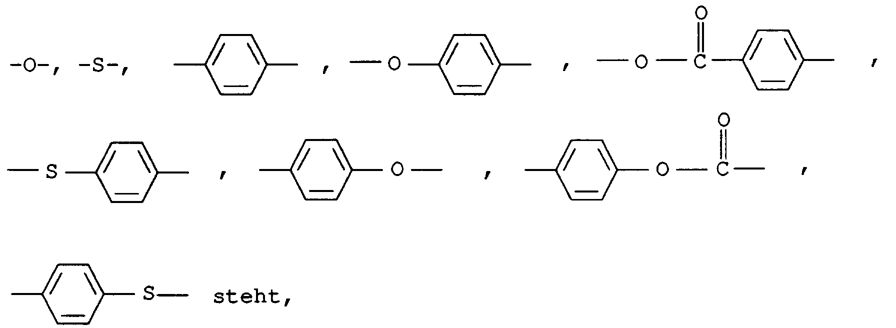
R¹ und R² untereinander gleich oder verschieden sind und für C₁- bis C₂₀-Alkyl, vorzugsweise C₃- bis C₁₂-Alkyl, C₂- bis C₂₀-Alkenyl, C₂- bis C₂₀-Alkinyl, Alkaryl mit 7 bis 20 Kohlenstoffatomen, C₁- bis C₁₂- Alkoxyaryl, Hydroxy-C₁- bis C₁₁-alkyl, Oxaalkyl mit 1 bis 5 Sauerstoffatomen und 3 bis 12 Kohlenstoffatomen, Wasserstoff, Halogen, wie z.B. F, Cl, Br, J, NO₂ oder CN stehen.

Die den erfindungsgemäßen Photoleitern zugrundeliegenden niedermolekularen organischen Verbindungen sind an sich bekannt und nach üblichen Verfahren (vgl. beispielsweise J. Prakt. Chem. 322 (1980) 933 ff; Mol. Cryst. Liq. Cryst. 191 (1990) 223 ff und 231 ff sowie Liquid Crystals 10 (1991) 397 ff) herstellbar.

Erfindungsgemäße polymere organische Photoleiter sind solche, die in der Polymerkette oder über einen flexiblen Spacer an eine Polymerkette gebunden photoleitfähige Gruppen enthalten. Zur Herstellung der polymeren organischen Photoleiter können beispielsweise entsprechend substituierte 1,3,4-Thiadiazole oder 1,3,4-Oxdiazole mit terminalen Hydroxygruppen, wie sie in Mol. Cryst. Liq. Cryst. 191 (1991) beschrieben sind, nach einem in DE-A 39 17 196 beschriebenen Verfahren acryliert und das so erhaltene Monomere, z.B. die Verbindung 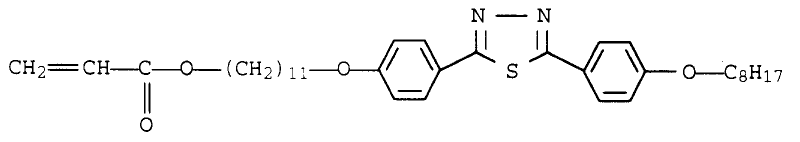
polymerisiert werden.

Zur Erhöhung der Lichtempfindlichkeit der Schichten können Sensibilisatoren, d.h. Ladungsträger erzeugende Verbindungen zugesetzt werden. Derartige Verbindungen sind z.B. die aus DE-A 22 37 539 und DE-A 31 10 955 bekannten Perylentetracarbonsäurederivate. Besonders bevorzugt sind Sensibilisatoren wie Rhodamin B (C.I. 45170) und Astrazonorange (C.I. 48035).

Die erfindungsgemäßen Photoleiter werden in der Regel in Form von dünnen photoleitenden Schichten verwendet, wobei auch eine Trennung des Ladungstransports von der Ladungserzeugung im Sinne einer Zweischichten-Anordnung möglich sein kann, wie sie in der Elektrophotographie angewandt wird. Hierbei befindet sich der erfindungsgemäße Photoleiter in der photoleitfähigen Ladungstransportschicht, an die eine übliche und bekannte Ladungsträger erzeugende Sensibilisatorschicht angrenzt. Die Aufladung erfolgt hierbei in der Regel durch eine Hochspannungscorona.

Die Erzeugung der erfindungsgemäßen Schichten auf einer Trägeroberfläche kann durch Auftragen einer Schmelze oder in üblicher und bekannter Weise z.B. durch Aufrakeln einer Lösung der Verbindungen auf eine Trägeroberfläche erfolgen. Dabei können der Lösung verschiedene Hilfsstoffe, z.B. zur Verbesserung der Verlaufeigenschaften, zugesetzt werden.

Als Lösungsmittel werden beispielsweise Tetrahydrofuran oder Dichlormethan verwendet.

Diese photoleitenden Schichten haben im allgemeinen eine Schichtdicke zwischen 1 und 100, vorzugsweise zwischen 1 und 50 und besonders bevorzugt zwischen 1 und 30 µm.

Die Photoleiter bzw. die photoleitenden Schichten können zwischen leitfähig beschichteten, transparenten Substraten angeordnet werden, für die Glasplatten oder Platten aus optisch transparenten Kunststoffen (beispielsweise Polymethylmethacrylat, Polycarbonat etc.) verwendet werden. Die leitfähige Beschichtung des Substrats kann aus elektrisch leitfähigen Polymeren, Halbleitern oder Metallen wie z.B. Aluminium, Silber oder Gold bestehen. Die Dicke der Beschichtung ist hierbei allerdings so zu wählen, daß die optische Durchlässigkeit nicht zu sehr beeinträchtigt wird. Besonders vorteilhafte Beschichtungen bestehen aus ITO ("indium tin oxide").

Zur Erzeugung eines Photostromes wird hierbei an die elektrisch leitfähig beschichteten Platten im allgemeinen eine Gleichspannung zwischen 5 und 50 V angelegt.

Der flüssigkristallin kalamitische Zustand, in dem die Photoleitfähigkeit höher ist als im ungeordneten, isotropen Zustand kann vorteilhafterweise durch eine homogen planare oder homöotrope Orientierung eingestellt werden. Die Orientierung der Ladungsträger kann z.B. mechanisch (durch Strecken oder Scheren) oder durch elektrische oder magnetische Felder erreicht werden. Die Einstellung einer Orientierung ist auch mittels orientierender Unterschichten, die z.B. Polyimide enthalten oder aus diesen bestehen, möglich. Die einfachste Möglichkeit ist eine thermische Behandlung (Tempern).

Die erfindungsgemäßen Photoleiter und photoleitfähigen Filme können in der Elektrophotographie, in Laserdruckern, im Offsetdruck, oder aber in der Mikroelektronik für lichtempfindliche Schalter verwandt werden. Darüberhinaus kann die Erfindung in all den Bereichen eingesetzt werden, in denen die Erhöhung der Photoleitfähigkeit durch molekulare Ordnung ausgenutzt wird.

Die Erfindung wird durch die nachfolgenden Beispiele erläutert.

Die Beispiele 1 bis 3 sind Beispiele für erfindungsgemäße Photoleiter und das erfindungsgemäße Verfahren zur Erhöhung der Photoleitfähigkeit. Beispiel 4 betrifft die Anwendungen in der Elektrophotographie.

In den Beispielen 1 bis 3 wurden die organischen Photoleiter wie folgt untersucht: Die zu untersuchende Substanz wird in einer Meßzelle bestehend aus zwei Glasplatten, die eine transparente, leitende Schicht aus Indium-Zinn-Oxid besitzen, präpariert. Die Schichtdicke der Probe beträgt ca. 10 µm, welche durch eine Polyester-Folie von 8 µm eingestellt ist. Die Elektrodenfläche beträgt 4 mm². An die Probe wird ein Gleichspannungssignal von 9 V angelegt, was einer anliegenden Feldstärke von ca. 900 kV m⁻¹ entspricht. Die Beleuchtung der Probe erfolgt mit einer Kaltlichtquelle. Der anfallende Lichtstrahl wird durch einen Chopper ("Lichtzerhacker") mit einer Frequenz von 10 Hz moduliert, d.h. in Lichtpulse von 50 msec Länge bei ebensolanger Dunkelphase zerlegt. Die Detektion des Photostroms erfolgt über den Spannungsabfall an einem Widerstand von 10 000 Ω mittels eines Lock-In-Verstärkers (EG&G5210). Um die Probe temperaturabhängig untersuchen zu können, wird sie in einem Heiztisch Mettler FP 80/82 temperiert.

### Beispiel 1

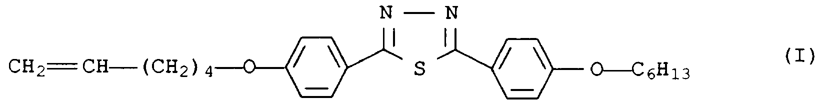

Das Thiadiazol (I) (Mol. Cryst. Liq. Cryst. 191, 223 ff (1990)) wurde als Reinsubstanz wie beschrieben zwischen zwei Glasplatten angeordnet und der Photostrom wie beschrieben beim Aufheizen bis auf 210°C gemessen. Die gefundenen Meßwerte sind in Tabelle 1 dargestellt.

**Tabelle 1**

| Temperatur [°C] | Photostrom [nA] | Phase |
|---|---|---|
| 45 | 4 | kristallin |
| 75 | 10 | kristallin |
| 110 | 48 | smektisch A |
| 160 | 105 | smektisch A |
| 175 | 60 | nematisch |
| 195 | 29 | nematisch |
| 210 | 9 | isotrop |

Wie sich aus der Tabelle ergibt, zeigt die Probe in den kalamitischen Phasen (smektisch A und nematisch) eine erhöhte Photoleitfähigkeit. Die Literaturwerte für die Phasenübergänge im Thiadiazol (I) sind: K 100°C S_{A} 182°C N 200°C I.

### Beispiel 2

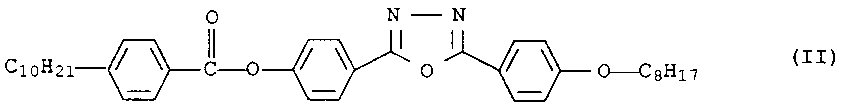

Das Oxdiazol (II) (Liquid Crystals 10, 397 ff (1991)) wurde mit 2 % Rhodamin B und 0,2 % Astrazonorange sensibilisiert und wie oben angegeben vermessen. Tabelle 2 gibt die gemessenen Photoströme wieder.

**Tabelle 2**

| Temperatur [°C] | Photostrom [nA] | Phase |
|---|---|---|
| 80 | 0,5 | kristallin |
| 110 | 64,4 | smektisch C |
| 120 | 38,5 | smektisch C |
| 130 | 17,6 | nematisch |
| 140 | 3,8 | nematisch |
| 150 | 1,6 | isotrop |

Auch hier zeigt die Probe in den kalamitischen Phasen (smektisch C, nematisch) eine erhöhte Photoleitfähigkeit. Die Phasenfolge der Mischung wurde wie folgt bestimmt: K 98°C S_{B} 102°C S_{C} 121°C N 125°C I.

### Beispiel 3

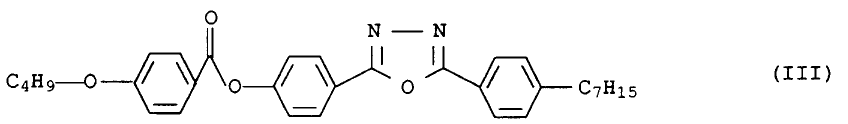

Eine Mischung aus Oxdiazol (III), 2 % Rhodamin B und 0,2 % Astrazonorange wurde wie oben vermessen. Die Meßergebnisse sind in Tabelle 3 angegeben. Die Mischung hat die Phasenfolge: K 99,8°C S_{A} 121°C I.

**Tabelle 3**

| Temperatur [°C] | Photostrom [nA] | Phase |
|---|---|---|
| 80 | 0,1 | kristallin |
| 90 | 1,4 | kristallin/smektisch A |
| 100 | 7,2 | smektisch A |
| 110 | 16,2 | smektisch A |
| 120 | 44,0 | smektisch A |

### Beispiel 4

### Elektrophotographisches Aufzeichnungsmaterial

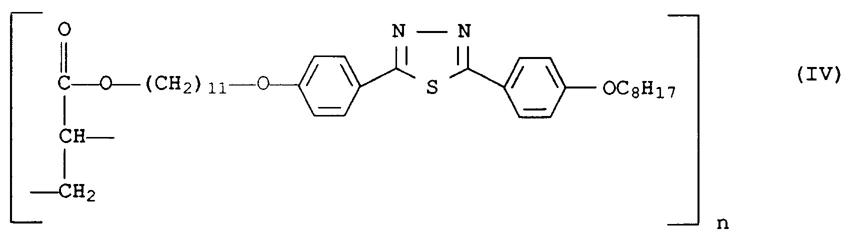

Zur Herstellung einer ladungsträgererzeugenden Schicht wurden 4,5 g des Sensibilisators N,N'-Bis(2',6'-dichlorphenyl)-perylen-3,4,9,10-tetracarbonsäurediimid (vgl. DE-A 31 10 955) mit 3,5 g eines Copolymerisats aus Vinylchlorid, Acrylsäure und einem Maleinsäurediester und 30 g Tetrahydrofuran vermischt und mehrere Stunden in einer Kugelmühle auf einem Walzenstuhl homogenisiert.

Die so erhaltene Dispersion wurde mit einer Rakel (Gießspalt 60 µm) auf ein unbehandeltes Aluminiumblech aufgetragen. Nach der Trocknung verblieb eine Trockenschichtdicke von ca. 1 µm.

Auf diese ladungsträgererzeugende Schicht wurde die Photoleiterschicht aufgetragen. Dazu wurde eine 10 gew.-%ige Lösung des Thiadiazol-polyacrylats (IV) (Herstellung vgl. Mol. Cryst. Liq. Cryst. 191, 223 ff (1990) und DE-A 39 17 196) in Tetrahydrofuran hergestellt. Der Phasenübergang des Polymeren vom Glaszustand zur nematischen Phase fand bei 45 bis 50°C statt, der Übergang zum isotropen Zustand bei 223°C. Die Lösung wurde mit einer Rakel (Gießspalt 150 µm) auf die wie beschrieben hergestellte ladungsträgererzeugende Schicht aufgebracht. Nach der Trocknung verblieb eine Schicht mit einer Schichtdicke von ca. 10 µm. Das Blech wurde bei 45°C mehrere Tage getempert.

Das auf diese Weise hergestellte elektrophotographische Aufzeichnungsmaterial konnte in üblicher und bekannter Weise mit einer Hochspannungscorona aus einem Abstand von 1 cm auf ein Potential von -650 V aufgeladen werden. Anschließend wurde es durch eine Negativvorlage hindurch bildmäßig belichtet, wodurch ein latentes Ladungsbild erzeugt wurde. Dieses konnte in üblicher Weise betonert werden. Anschließend wurde das Tonerbild auf Papier übertragen und darauf fixiert. Das übertragene und fixierte Tonerbild gab die Motive der Negativvorlage detailgetreu wieder.

## Patentansprüche

1. Photoleiter aus niedermolekularen oder polymeren organischen Verbindungen mit flüssigkristallinen Eigenschaften, dadurch gekennzeichnet, daß dessen Photoleitung in den kalamitischen Phasen höher als in den nichtflüssigkristallinen Phasen ist.

2. Photoleiter nach Anspruch 1, dadurch gekennzeichnet, daß der Photoleiter ein Thiadiazol-, Oxdiazol- oder Carbazolderivat ist.

3. Photoleiter nach Anspruch 1 oder 2, dadurch gekennzeichnet, daß er einen Zusatz einer ladungserzeugenden Komponente (Sensibilisator) enthält.

4. Verwendung flüssigkristalliner Phasen von niedermolekularen oder polymeren kalamitischen Photoleitern nach einem der Ansprüche 1 bis 3 für Ladungsträgerschichten in elektrophotographischen Aufzeichnungsmaterialien.

5. Elektrophotographisches Aufzeichnungsmaterial, bestehend aus einem elektrisch leitenden Schichtträger, einer Ladungsträger erzeugenden Sensibilisatorschicht und einer photoleitfähigen Schicht, dadurch gekennzeichnet, daß es als photoleitfähige Schicht einen oder mehrere Photoleiter nach einem der Ansprüche 1 bis 3 enthält.

6. Verfahren zur Erhöhung der Photoleitfähigkeit in Photoleitern mit kalamitischen Eigenschaften nach Anspruch 1 bis 3, dadurch gekennzeichnet, daß die Erhöhung der Photoleitfähigkeit durch eine homogen planare oder homöotrope Orientierung der Ladungsträgermoleküle erreicht wird.

7. Verfahren nach Anspruch 6, dadurch gekennzeichnet, daß die Ladungsträgermoleküle durch mechanisches Scheren oder Strecken, durch Anlegen eines elektrischen oder magnetischen Feldes oder durch thermische Behandlung orientiert werden.
